# EUROPEAN PATENT APPLICATION

(11) **EP 4 503 407 A1**
(43) Date of publication of application: **05.02.2025**
(21) Application number: 24192614.6
(22) Date of filing: 02.08.2024
(51) Int. Cl.: H02K 15/03, G01R 31/34, H01F 41/02

(54) **METHOD OF MAGNETIC ORIENTATION DETERMINATION OF INJECTION MOLDED PERMANENT MAGNETS**

(30) Priority: 02.08.2023 US 202318363850
(71) Applicant: ABB SCHWEIZ AG, 5400 Baden (CH)
(72) Inventor: PERIGO, Elio Alberto, 5400 Baden (CH); ZHONG, Sheng, 5400 Baden (CH); TREMELLING, Darren Dale, 5400 Baden (CH); HOFFMAN, Matthew Dodge, 5400 Baden (CH)
(74) Representative: Zimmermann & Partner Patentanwälte mbB

(57) **Abstract**

A method of monitoring a magnetic orientation of a composite magnetic material injected into a rotor pole of a rotor core. The rotor pole is defined by at least one rotor cavity. The method includes injecting a magnetic composite material into the at least one rotor cavity defining the rotor pole and applying an external magnetic field to the rotor pole to magnetically orient the magnetic composite material during injection into the at least one rotor cavity.

## Description

### BACKGROUND

The field of the disclosure relates generally to the measurement of properties of permanent magnet (PM) synchronous reluctance machine (PMSynRM) rotors, and more particularly to systems and methods for determining the magnetic orientation of permanent magnets installed in PMSynRM rotors.

Permanent magnet (PM) synchronous reluctance machines (PMSynRM) might utilize polymer bonded magnets (PBMs) in their construction. When sintered magnets are utilized in PMSynRMs, the discrete pieces are previously oriented during manufacturing and shipped to customers (e.g., motor manufacturers) for final assembly and magnetization.

In molded PMSynRM rotors, the filling of PBMs in the rotor cavities is completed using a suitable molding process. During production of a PMSynRM rotor, a laminated rotor with cavities is placed in a mold cavity. The material comprising PBM is injected into the cavities through a runner and gate system. The magnetic field generated by the PBM relies on the magnetic orientation of the permanent magnets. As a result, the produced rotor may generate magnetic fields having inconsistent magnitudes that are formed during the injection process and after the rotor has cooled.

Therefore, there is a need to monitor the magnetic field generated by the PBM during and after the injection process such that the manufacturing yield is improved.

### BRIEF DESCRIPTION

In one aspect of the present disclosure, a method of monitoring a magnetic orientation of a rotor pole of a rotor core positioned in an injection mold is disclosed. The rotor pole is defined by at least one rotor cavity. The method includes injecting a magnetic composite material into the at least one rotor cavity defining the rotor pole and applying an external magnetic field to the rotor pole to magnetically orient the magnetic composite material injected into the at least one rotor cavity.

In another aspect of the present disclosure, a method of determining a magnetic field orientation of a rotor pole of a rotor core. The rotor pole is defined by at least one rotor cavity filled with a magnetic composite material. The method includes measuring a magnitude of a magnetic field of the rotor pole generated by the magnetic composite material and assessing the magnitude of the magnetic field of the rotor pole against at least one of a first threshold magnetic field magnitude value and a second threshold magnetic field magnitude value, wherein the first threshold magnetic field magnitude value corresponds to a first known magnetic field orientation and the second threshold magnetic field magnitude value corresponds to a second magnetic field orientation. Each of the first threshold magnetic field magnitude value and the second threshold magnetic field magnitude value may be generated by a control material, the control material and the magnetic composite material having a material composition and a temperature in common, wherein the control material is injected into at least one control rotor cavity defining a control rotor pole of a control rotor core. Each of the at least one rotor cavity and the at least one control rotor cavity may have at least one of a volume, a surface geometry and an orientation in common, the orientation being defined along a top surface of the rotor core. The magnitude of the magnetic field of the rotor pole may be proportional to a magnetic orientation of the magnetic composite material within the rotor pole. A proportion of the magnitude of the magnetic field of the rotor pole to the magnetic orientation of the magnetic composite material within the rotor pole may be approximately 0.5 for a substantially isotropic composite material. A proportion of the magnitude of the magnetic field of the rotor pole to the magnetic orientation of the magnetic composite material within the rotor pole may be approximately 1 for a substantially anisotropic composite material. The method may further comprise determining a degree of magnetic orientation of the magnetic composite material injected into the rotor core as part of a motor assembly, the motor assembly including at least a rotor shaft and a stator assembly, wherein the determining of the degree of magnetic orientation of the magnetic composite material injected into the rotor core comprises: rotating the rotor core at a minimum rotational speed; measuring a magnitude of back-EMF voltage of the motor assembly; and, assessing the magnitude of the back-EMF voltage against a threshold back-EMF voltage value, wherein the threshold back-EMF voltage value is that of a control motor assembly having a control rotor core, a rotor shaft, and a control stator assembly, wherein the magnitude of the back-EMF voltage of the motor assembly is proportional to the degree of magnetic orientation of the magnetic composite material injected into the rotor core.

### BRIEF DESCRIPTION OF THE DRAWINGS

The subject-matter of the disclosure will be explained in more detail in the following text with reference to exemplary embodiments which are illustrated in the attached drawings.
FIG. 1 illustrates a top view of a PMSynRM rotor core;
FIG. 2 illustrates a cross-sectional side view of the rotor core taken along line A-A as shown in FIG. 1;
FIG. 3A illustrates a detailed view of DETAIL A as shown in FIG. 1 of an isotropic magnet with substantially randomized easy magnetization axes;
FIG. 3B illustrates a detailed view of DETAIL A as shown in FIG. 1 of an anisotropic magnet with substantially parallel easy magnetization axes;
FIG. 4 illustrates a top view of a system for monitoring the magnetic orientation of at least one rotor pole of a rotor core positioned in an injection mold;
FIG. 5 illustrates a side view of the system shown in FIG. 4 for monitoring the magnetic orientation of at least one rotor pole of the rotor core positioned in the injection mold;
FIG. 6 illustrates a method of monitoring the magnetic orientation of at least one rotor pole of a rotor core positioned in an injection mold;
FIG. 7 illustrates a side view of a system for determining a magnetic field orientation of at least one rotor pole of a rotor core;
FIG. 8 illustrates a method for determining a magnetic field orientation of at least one rotor pole of a rotor core;
FIG. 9 illustrates a system for determining a degree of magnetic orientation of a magnetic composite material injected into a rotor core of a motor assembly; and,
FIG. 10 illustrates a method for determining a degree of magnetic orientation of a magnetic composite material injected into a rotor core of a motor assembly.

The reference symbols used in the drawings, and their meanings, are listed in summary form in the list of reference symbols. In principle, identical parts are provided with the same reference symbols in the figures.

### DETAILED DESCRIPTION

In the following specification and the claims, reference will be made to a number of terms, which shall be defined to have the following meanings.

As used herein, the singular forms "a," "an," and "the" include plural references unless the context clearly dictates otherwise. The terms "comprising," "including," and "having" are intended to be inclusive and mean that there may be additional elements other than the listed elements. The terms "optional" or "optionally" means that the subsequently described event or circumstance may or may not occur, and that the description includes instances where the event occurs and instances where it does not.

Unless otherwise indicated, approximating language, such as "generally," "substantially," and "about," as used herein, indicates that the term so modified may apply to only an approximate degree, as would be recognized by one of ordinary skill in the art, rather than to an absolute or perfect degree. Accordingly, a value modified by a term or terms, such as "about," "approximately," and "substantially," is not to be limited to the precise value specified. In at least some instances, the approximating language may correspond to the precision of an instrument for measuring the value. Here and throughout the specification and claims, range limitations may be identified. Such ranges may be combined and/or interchanged, and include all the sub-ranges contained therein unless context or language indicates otherwise.

Additionally, unless otherwise indicated, the terms "first," "second," etc. are used herein merely as labels, and are not intended to impose ordinal, positional, or hierarchical requirements on the items to which these terms refer. Moreover, reference to, for example, a "second" item does not require or preclude the existence of, for example, a "first" or lower-numbered item or a "third" or higher-numbered item.

In summary, embodiments of the disclosure are directed to a method of monitoring a magnetic orientation of a composite magnetic material injected into a rotor pole of a rotor core. The rotor pole is defined by at least one rotor cavity. The method includes injecting a magnetic composite material into the at least one rotor cavity defining the rotor pole and applying an external magnetic field to the rotor pole to magnetically orient the magnetic composite material injected into the at least one rotor cavity.

In some embodiments, the method is of determining a magnetic field orientation of a rotor pole of a rotor core. The rotor pole is defined by at least one rotor cavity filled with a magnetic composite material. The method includes measuring a magnitude of a magnetic field of the rotor pole generated by the magnetic composite material and assessing the magnitude of the magnetic field of the rotor pole against at least one of a first threshold magnetic field magnitude value and a second threshold magnetic field magnitude value, wherein the first threshold magnetic field magnitude value corresponds to a first known magnetic field orientation and the second threshold magnetic field magnitude value corresponds to a second magnetic field orientation.

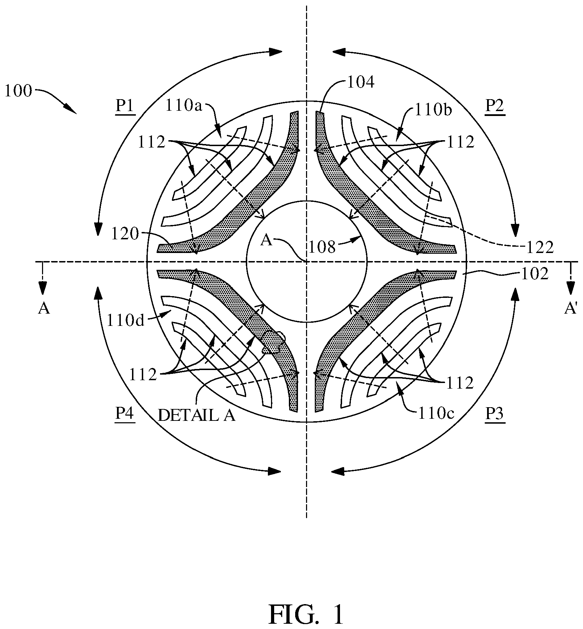

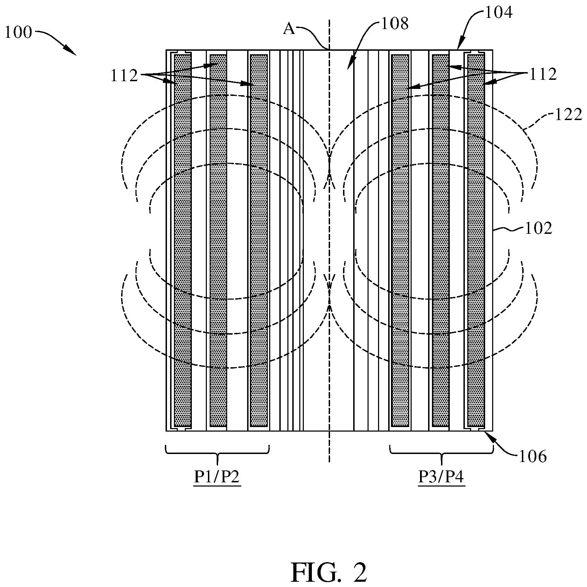

FIG. 1 illustrates a top view of a rotor core 100 and FIG. 2 illustrates a cross-sectional side view of the rotor core 100 taken along line A-A as shown in FIG. 1. The rotor core 100 is a component part of a motor assembly which includes a rotor shaft, a rotor, and a stator (not shown). In the example embodiment, the rotor core 100 is a permanent magnet synchronous reluctance machine (PMSynRM) rotor core. In the embodiment shown in FIG. 1, the rotor core 100 comprises a cylindrical body 102 referred to hereinafter as a rotor stack 102. In some embodiments, the rotor stack 102 is comprised of two or more cylindrical bodies.

As used herein, the term "electric motor" denotes an electrical machine which converts electrical energy into mechanical energy. The electric motor operates through the interaction between the magnetic fields formed in wire windings of a stator and integrated magnets of the rotor to generate force in the form of torque applied on a rotor shaft. An electric generator converts mechanical energy to electrical energy. The components generally comprising a stator, rotor, conductors and housing may be provided in both the generator and the motor. Therefore, because the electric generator and the motor are similar in their operability and mechanical aspects, it should be understood that the mechanical aspects of the electric motors described herein also describe an electrical generator, and the term electric motor also includes electric generators.

As shown in FIGS. 1 and 2, the rotor stack 102 includes a top surface 104 and a bottom surface 106. The rotor stack 102 has a central longitudinal axis A extending along a length of the rotor stack 102 defined between the top surface 104 and the bottom surface 106. A shaft bore 108, which is centrally located, extends longitudinally along central longitudinal axis A of the rotor stack 102. The shaft bore 108 of the rotor stack 102 is adapted to receive a rotor shaft therethrough. The rotor shaft may be secured to the rotor stack 102 by a friction fit, a weld or adhesive, or by the use of a key which can be inserted into one or more keyways located on an inner surface of the shaft bore 108. In some embodiments, the rotor shaft may be secured to the rotor stack 102 by c-clips.

The rotor stack 102 includes at least two rotor poles 110. The present embodiment of the disclosure includes four rotor poles 110a, 110b, 110c and 110d. Each of the rotor poles 110a-d includes at least one rotor stack cavity 112. In the present disclosure each rotor pole 110a-d includes three rotor stack cavities 112. Each rotor stack cavity 112 extends longitudinally through the rotor stack 102 (e.g., extends parallel to the central longitudinal axis A). As shown in FIG. 1 for purposes of illustration, the top surface 104 of the rotor stack 102 is illustratively divided into four portions (P1, P2, P3, P4) that comprises approximately ninety degrees of the circular rotor stack 102. Each rotor pole 110a, 110b, 110c and 110d is located in a respective portion P1, P2, P3 and P4. The rotor core 100 as described herein including four rotor poles 110 is an exemplary configuration and the number of rotor poles 110 as illustrated is not intended to be limiting. The rotor core 100 may have any number of rotor poles 110, and the top rotor surface 104 may be illustratively divided such that each of the rotor poles 110 (and the plurality of rotor stack cavities 112) are symmetrically oriented about the central longitudinal axis A. Similarly, the number of rotor stack cavities 112 as illustrated is an exemplary configuration (e.g., the number of rotor stack cavities 112 for each rotor pole 110) and is not intended to be limiting.

The plurality of rotor stack cavities 112 can be filled with magnetic composite material 120. In some embodiments, the magnetic composite material 120 is in a molten state. In other embodiments, the magnetic composite material 120 is in a solidified state (at room temperature). The magnetic composite material 120 may be magnetizable. In some embodiments, the magnetic composite material 120 is magnetizable during an injection process in which a magnetic field is applied to the magnetic composite material 120 as it is injected into the plurality of rotor stack cavities 112. As shown in FIGS. 1 and 2, a magnetic field 122 is generated by the magnetic composite material 120, with the orientation of the magnetic field 122 being illustrated by dashed lines and/or arrows. The orientation of the magnetic field 122 as illustrated is merely exemplary and is not intended to be limiting.

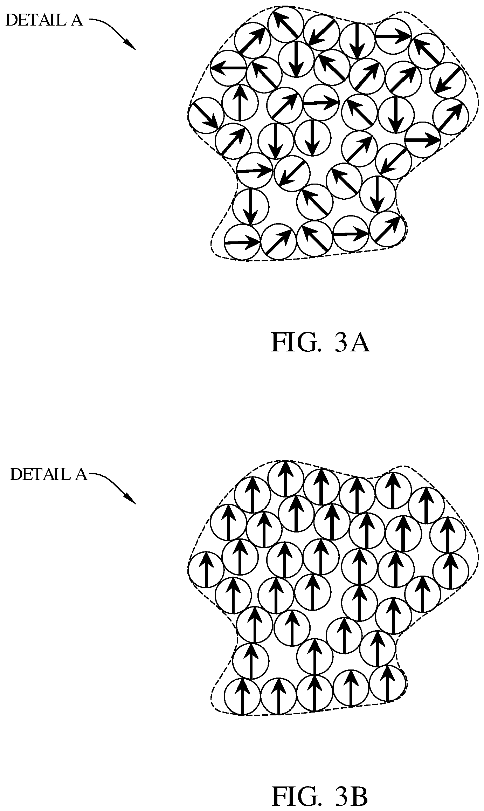

The performance of the rotor and/or the motor generally is proportional to the orientation and magnitude of the magnetic field 122 as generated by the magnetic composite material 120. The orientation of the magnetic field 122 is characterized by the magnetic anisotropy of the magnetic composite material 120 in a solid state. The magnetic composite material 120 and the orientation of the magnetic field 122 can be defined by a distribution of easy magnetization axes. Isotropic magnetic material is defined by substantially randomized easy magnetization axes, and anisotropic magnetic material is defined by substantially parallel easy magnetization axes. By way of example, FIG. 3A illustrates a detailed view of DETAIL A as shown in FIG. 1 of an isotropic magnet with substantially randomized easy magnetization axes. FIG. 3B illustrates a detailed view of DETAIL A as shown in FIG. 1 of an anisotropic magnet with substantially parallel easy magnetization axes. The value of *θ* (degree of crystallographic orientation) for an isotropic magnetic material is approximately 0.50, and the value of *θ* for an anisotropic magnetic material is approximately 1.00. An anisotropic magnetic material generates a stronger magnetic field relative to a partially isotropic magnetic material and relative to a fully isotropic magnetic material.

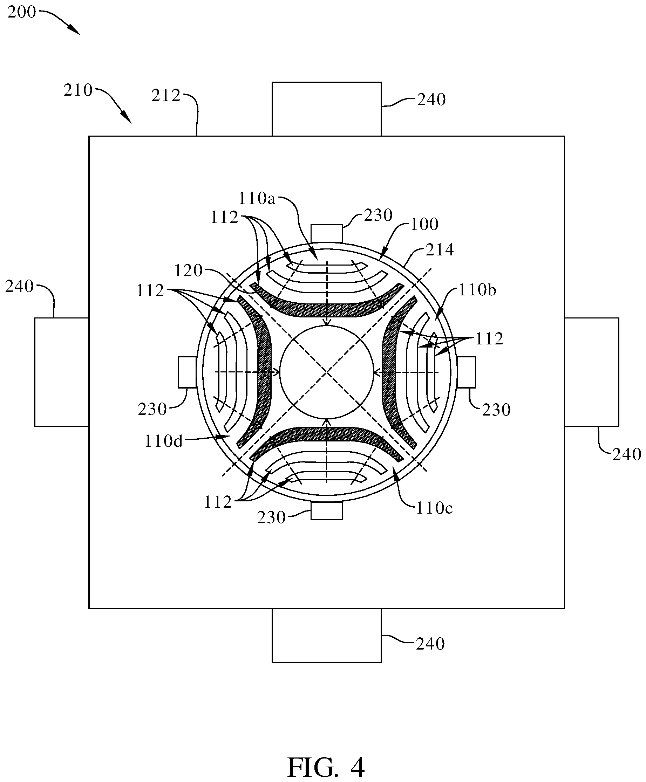

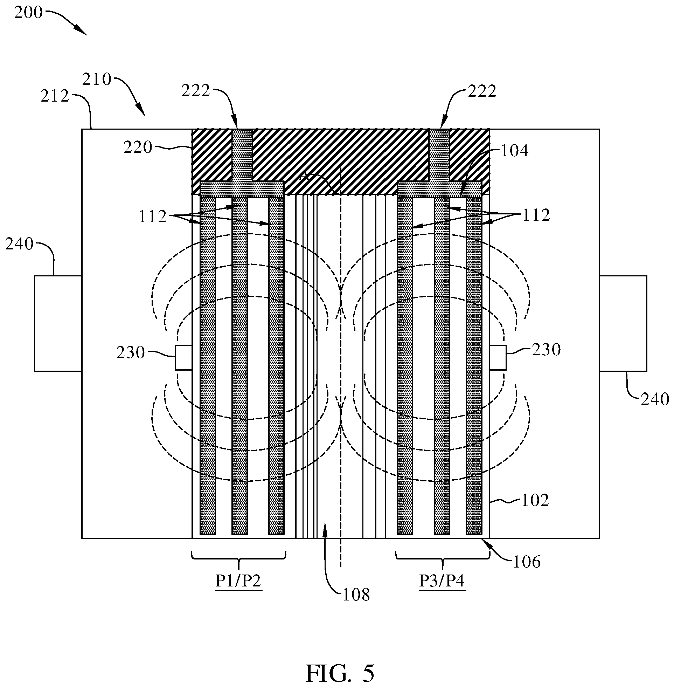

FIG. 4 illustrates a top view of a system 200 for monitoring the magnetic orientation of at least one rotor pole 110 of the rotor core 100 positioned in an injection mold 210. FIG. 5 illustrates a side view of the system 200. As shown in FIGS. 4 and 5, the injection mold 210 includes a mold body 212 having a cavity 214 into which the rotor core 100 is positioned. A distribution plate 220 (shown in FIG. 5) includes injection channels 222 to facilitate filling of the rotor stack cavities 112 with the molten composite material 120. The system 200 includes a plurality of sensors 230 positioned in the injection mold 210 for measuring a magnitude of a magnetic field of the rotor pole 110 as generated by the magnetic composite material 120. Each sensor 230 is positioned proximate the mold body 212 for a respective rotor pole 110, at a position corresponding to the rotor poles 110. In some embodiments, the sensors 230 are Hall effect sensors, and/or current sensors. The system 200 also includes conduction coils 240 external to the mold body 212 to facilitate straightening the magnetic composite material 120 as it is injected into the rotor stack cavities 112. The external magnetic field generated by each of the conduction coils 240 is oriented perpendicular to the respective rotor pole 110.

In operation, as the magnetic composite material 120 is injected through the injection channels 222 of the distribution plate 220, a current passes through the conduction coils 240 to straighten and align the magnetic orientation of the magnetic composite material 120. Concurrently, the sensor 230 measures magnetic flux of the magnetic composite material 120 while the magnetic composite material 120 is molten and as it solidifies. The measurement is therefore performed during the injection process.

The magnetic flux measurement is assessed against a known magnetic flux measurement from a control rotor core (not shown). The control rotor core has the same geometry, mechanical characteristics, and material characteristics as the rotor core 100. The control rotor core also has the same magnetic composite material injected into cavities of the control rotor core by the same process. Because magnetic flux measurements are temperature-dependent, the known magnetic flux measurement also has a corresponding known rotor core temperature.

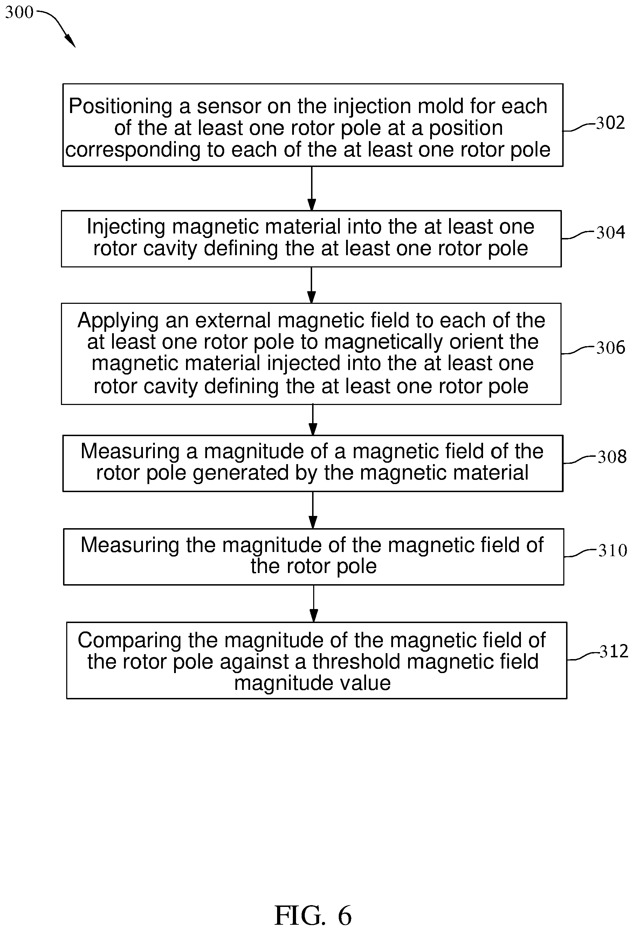

FIG. 6 illustrates a method 300 of monitoring the magnetic orientation of at least one rotor pole of a rotor core positioned in an injection mold, such as of the rotor pole 110 of the rotor core 100 positioned in the injection mold 210. The method 300 includes positioning 302 a sensor on the injection mold for each of the at least one rotor pole at a position corresponding to each of the at least one rotor pole and injecting 304 magnetic material into the at least one rotor cavity defining the at least one rotor pole. The method 300 also includes applying 306 an external magnetic field to each of the at least one rotor pole to magnetically orient the magnetic material injected into the at least one rotor cavity defining the at least one rotor pole and measuring 308 a magnitude of a magnetic field of the rotor pole generated by the magnetic material. The method 300 further includes measuring 310 the magnitude of the magnetic field of the rotor pole and comparing 312 the magnitude of the magnetic field of the rotor pole against a threshold magnetic field magnitude value.

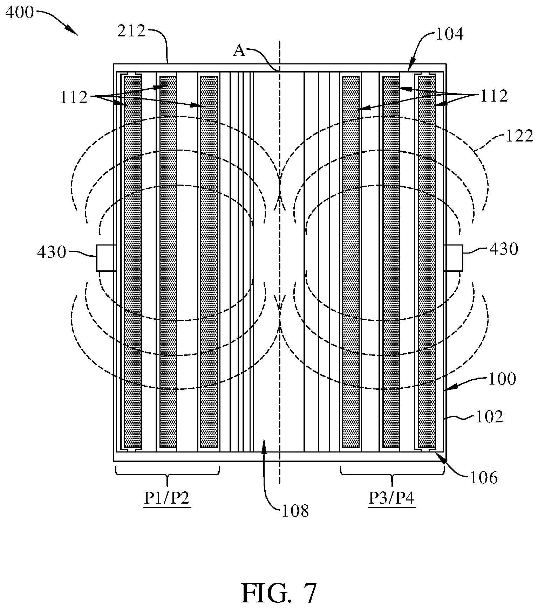

FIG. 7 illustrates a side view of a system 400 for determining a magnetic field orientation of at least one rotor pole 110 of the rotor core 100. Unlike the system and method described in FIGS. 4-6, in FIG. 7 the injection process has been completed and the magnetic composite material 120 has solidified. Similar to the system 200, shown in FIGS. 4 and 5, a plurality of sensors 430 are positioned on the rotor core 100 for measuring a magnitude of a magnetic field of the rotor pole 110 as generated by the magnetic composite material 120. A sensor 430 is positioned on the mold body 212 for each of the rotor poles 110, and at a position corresponding to each rotor pole 110. In some embodiments, the sensors 430 are Hall effect sensors, current sensors and/or gauss sensors.

The magnetic flux measurement is assessed against a known magnetic flux measurement from a control rotor core (not shown). The control rotor core has the same geometry, mechanical characteristics, and material characteristics as the rotor core 100. The control rotor core also has the same magnetic composite material injected into cavities of the control rotor core by the same process. Because magnetic flux measurements are temperature-dependent, the known magnetic flux measurement also has a corresponding known temperature. In some embodiments, a range of known magnetic flux measurements of the control rotor core corresponds to a range of temperatures.

The measured magnitude of the magnetic field is assessed against an upper and lower threshold value, where the upper threshold value corresponds to an anisotropic magnetic material defined by substantially parallel easy magnetization axes and the lower threshold value corresponds to an isotropic magnetic material defined by substantially randomized easy magnetization axes. As previously set forth, the degree of crystallographic orientation value *θ* for an isotropic magnetic material is approximately 0.50, and the degree of crystallographic orientation value *θ* for an anisotropic magnetic material is approximately 1.00.

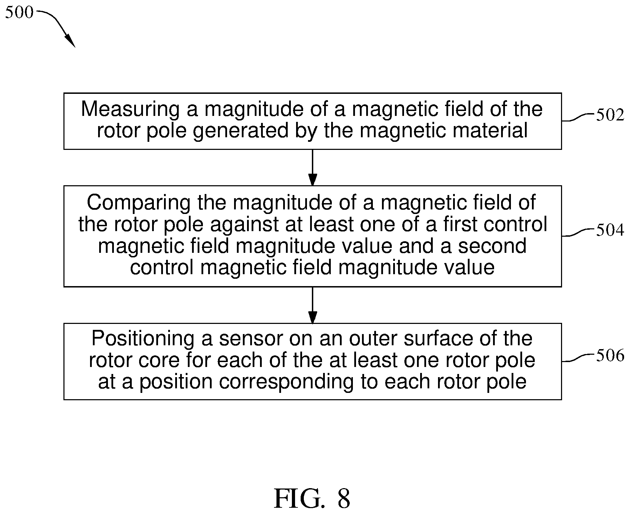

FIG. 8 illustrates a method 500 for determining a magnetic field orientation of at least one rotor pole of a rotor core, such as of the rotor pole 110 of the rotor core 100. The method 500 includes measuring 502 a magnitude of a magnetic field of the rotor pole generated by a magnetic material. The method 500 further includes assessing 504 the magnitude of the magnetic field of the rotor pole against at least one of a first control magnetic field magnitude value and a second control magnetic field magnitude value. The first control magnetic field magnitude value and the second control magnetic field magnitude value each correspond, respectively, to a first magnetic field orientation and a second magnetic field orientation.

As previously set forth, the magnetic material has at least one of a material composition and a temperature. The first control magnetic field magnitude value and the second magnetic field magnitude value are generated by a control magnetic material having the same material composition and temperature as the magnetic material. The magnitude of a magnetic field of the rotor pole generated by the magnetic material is proportional to half of a *θ* value. The first magnetic field orientation is that of a substantially isotropic magnetic material having a *θ* value of approximately 0.5 and the second magnetic field orientation is that of a substantially anisotropic magnetic material having a *θ* value of approximately 1.

The method 500 further includes positioning 506 a sensor on an outer surface of the rotor core for each of the at least one rotor pole at a position corresponding to each rotor pole.

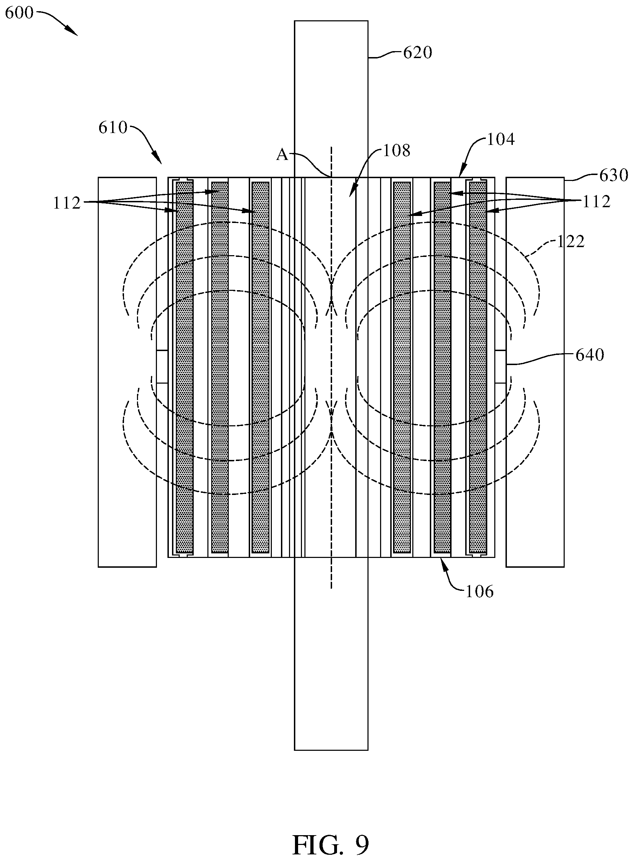

FIG. 9 illustrates a system 600 for determining a degree of magnetic orientation of the magnetic composite material injected into the rotor core 100 assembled into a motor assembly 610. A rotor shaft 620 is affixed to the rotor core 100 and the rotor core 100 is positioned within a stator 630. Back-EMF voltage sensors 640 are connected to the motor assembly 610, and the stator is energized such that the rotor 100 rotates about the rotor shaft 620. The rotor shaft 620 is rotated at a known, minimum speed such that the back-EMF voltage can be measured. The back-EMF voltage measurement can then be assessed against a threshold back-EMF voltage value of a control motor assembly (not shown) having the same specification as the motor assembly 610 and the rotor core 100. The magnitude of the back-EMF voltage of the motor assembly 610 is proportional to the degree of magnetic orientation of the magnetic composite material injected into the rotor core 100.

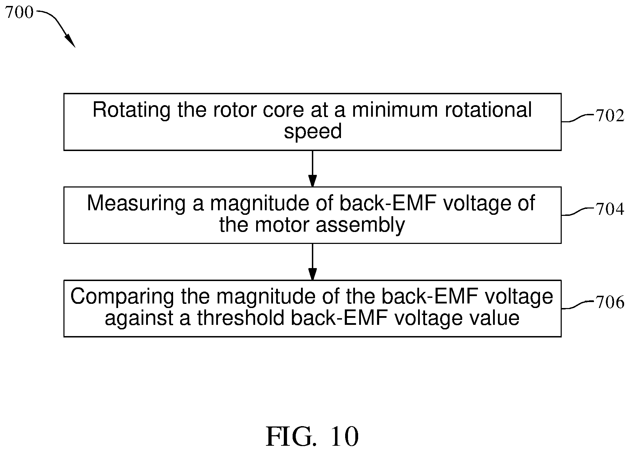

FIG. 10 illustrates a method 700 for determining a degree of magnetic orientation of the magnetic composite material injected into a rotor core of a motor assembly, such as of the rotor core 100 of the motor assembly 610. The method includes rotating 702 the rotor core at a minimum rotational speed and measuring 704 a magnitude of back-EMF voltage of the motor assembly. The method 700 further includes assessing 706 the magnitude of the back-EMF voltage against a threshold back-EMF voltage value. The threshold back-EMF voltage value is that of a control motor assembly having a control rotor core, a rotor shaft and a control stator assembly which is the same as the motor assembly 610. The magnitude of the back-EMF voltage of the motor assembly is proportional to the degree of magnetic orientation of the magnetic composite material injected into the rotor core.

Although specific features of various embodiments may be shown in some drawings and not in others, this is for convenience only. Moreover, references to "one embodiment" in the above description are not intended to be interpreted as excluding the existence of additional embodiments that also incorporate the recited features. In accordance with the principles of the disclosure, any feature of a drawing may be referenced and/or claimed in combination with any feature of any other drawing.

This written description uses examples, including the best mode, to enable any person skilled in the art to practice the disclosure, including making and using any devices or systems and performing any incorporated methods. The patentable scope of the disclosure is defined by the claims, and may include other examples that occur to those skilled in the art. Such other examples are intended to be within the scope of the claims if they have structural elements that do not differ from the literal language of the claims, or if they include equivalent structural elements with insubstantial differences from the literal languages of the claims.

## Claims

1. A method (300) of monitoring a magnetic orientation of a composite magnetic material injected into a rotor pole (110) of a rotor core (100), the rotor pole defined by at least one rotor cavity (112), the method comprising:
injecting (304) a magnetic composite material into the at least one rotor cavity defining the rotor pole; and
applying (306) an external magnetic field to the rotor pole to magnetically orient the magnetic composite material during injection into the at least one rotor cavity.

2. The method of claim 1, further comprising measuring (308) a magnitude of a magnetic field of the rotor pole generated by the magnetic composite material.

3. The method of claim 2, further comprising assessing (310, 312) the magnitude of the magnetic field of the rotor pole against a threshold magnetic field magnitude value.

4. The method of claim 3, wherein the magnetic composite material has at least one of a material composition and a temperature, the magnitude of the magnetic field depending on at least one of the material composition and the temperature.

5. The method of claim 4, wherein the threshold magnetic field magnitude value is generated by a control material, the control material and the magnetic composite material having the material composition and the temperature in common, wherein the control material is injected into at least one control rotor cavity (112) defining a control rotor pole (110) of a control rotor core (100).

6. The method of claim 5, wherein each of the at least one rotor cavity and the at least one control rotor having has at least one of a volume, a surface geometry and an orientation in common, the orientation of the at least one rotor cavity being defined on a top surface (104) of the rotor core.

7. The method of any one of claims 3 to 6, wherein the rotor core comprises a plurality of rotor poles (110), wherein the magnitude of the magnetic field of each of the plurality of rotor poles is assessed.

8. The method of any one of claims 3 to 7, wherein the magnitude of the magnetic field of the rotor pole is proportional to the magnetic orientation of the magnetic composite material within the rotor pole.

9. The method of claim 8, wherein a proportion of the magnitude of the magnetic field of the rotor pole to the magnetic orientation of the magnetic composite material within the rotor pole is approximately 0.5 for a substantially isotropic composite material.

10. The method of claim 8 or 9, wherein a proportion of the magnitude of the magnetic field of the rotor pole to the magnetic orientation of the magnetic composite material within the rotor pole is approximately 1 for a substantially anisotropic composite material.

11. The method of any one of claims 2 to 10, wherein the magnitude of the magnetic field of the rotor pole generated by the magnetic composite material is measured by a sensor (230), the sensor being positioned proximate the rotor pole.

12. The method of claim 11, wherein the sensor is a Hall effect sensor.

13. The method of any one of claims 3 to 10, further comprising measuring at least one of an amplitude and a polarity of the magnetic field generated by the magnetic composite material.
